# EUROPEAN PATENT APPLICATION

(11) **EP 4 636 811 A1**
(43) Date of publication of application: **22.10.2025**
(21) Application number: 23911755.9
(22) Date of filing: 14.12.2023
(51) Int. Cl.: H01L 21/3065, H01L 21/304

(54) **SUBSTRATE PROCESSING METHOD AND SUBSTRATE PROCESSING DEVICE**

(30) Priority: 28.12.2022 JP 2022211964
(71) Applicant: Tokyo Electron Limited, Tokyo 107-6325 (JP)
(72) Inventor: NAKANE, Yuta, Kurokawa-gun, Miyagi 981-3629 (JP); ONO, Kenta, Kurokawa-gun, Miyagi 981-3629 (JP); KUMAKURA, Sho, Kurokawa-gun, Miyagi 981-3629 (JP)
(74) Representative: Piotrowicz, Pawel Jan Andrzej
(86) International application number: PCT/JP2023/044866
(87) International publication number: WO 2024/142974

(57) **Abstract**

In one example embodiment, a substrate processing method includes (a) providing a substrate including a silicon-containing film and a metal-containing film on the silicon-containing film, the metal-containing film including at least one opening; (b) etching the silicon-containing film with plasma generated from a first process gas including a fluorine-containing gas; and (c) removing a residue generated in the (b) by supplying a second process gas different from the first process gas, the residue including a metal and fluorine included in the metal-containing film.

## Description

### Technical Field

Example embodiments of the present disclosure relate to a substrate processing method and a substrate processing apparatus.

### Background Art

Patent Literature 1 relates to a pattern forming method for a semiconductor device and discloses a technique of using a thin tin oxide film as an etching mask.

### Citation List

### Patent Literature

[Patent Literature 1] Japanese Unexamined Patent Publication No. 2018-6742

### Summary of Invention

### Technical Problem

The present disclosure provides a substrate processing method and a substrate processing apparatus capable of removing residues.

### Solution to Problem

In one example embodiment, a substrate processing method includes (a) providing a substrate including a silicon-containing film and a metal-containing film on the silicon-containing film, the metal-containing film including at least one opening; (b) etching the silicon-containing film with plasma generated from a first process gas including a fluorine-containing gas; and (c) removing a residue generated in the (b) by supplying a second process gas different from the first process gas, the residue including a metal and fluorine included in the metal-containing film.

### Advantageous Effects of Invention

According to one example embodiment, there are provided a substrate processing method and a substrate processing apparatus capable of removing residues.

### Brief Description of Drawings

FIG. 1 is a schematic diagram illustrating the substrate processing apparatus according to an example embodiment.
FIG. 2 is a schematic diagram illustrating the substrate processing apparatus according to an example embodiment.
FIG. 3 is a flowchart illustrating a substrate processing method according to an example embodiment.
FIG. 4 is a cross-sectional view of an example of a substrate to which the method in FIG. 3 may be applied.
FIG. 5 is a cross-sectional view illustrating a step of the substrate processing method according to an example embodiment.
FIG. 6 is a cross-sectional view illustrating a step of the substrate processing method according to an example embodiment.
FIG. 7 is a cross-sectional view illustrating a step of the substrate processing method according to an example embodiment.
FIG. 8 is a schematic diagram illustrating a part of the substrate processing apparatus according to an example embodiment.
FIG. 9 is a flowchart illustrating a substrate processing method according to an example embodiment.
FIG. 10 is a cross-sectional view of an example of a substrate to which the method in FIG. 9 may be applied.
FIG. 11 is a cross-sectional view illustrating a step of the substrate processing method according to an example embodiment.
FIG. 12 is a cross-sectional view illustrating a step of the substrate processing method according to an example embodiment.
FIG. 13 is a cross-sectional view illustrating a step of the substrate processing method according to an example embodiment.
FIG. 14 is a schematic diagram illustrating the substrate processing apparatus according to an example embodiment.

### Description of Embodiments

Hereinafter, various example embodiments will be described in detail with reference to the drawings. In the drawing, the same or equivalent portions are denoted by the same reference signs.

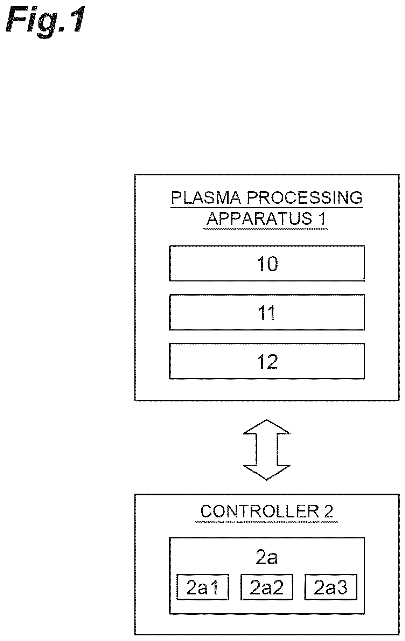

Fig. 1 illustrates an example configuration of a plasma processing system. In an embodiment, the plasma processing system includes a plasma processing apparatus 1 and a controller 2. The plasma processing system is an example substrate processing system, and the plasma processing apparatus 1 is an example substrate processing apparatus. The plasma processing apparatus 1 includes a plasma processing chamber 10, a substrate support 11, and a plasma generator 12. The plasma processing chamber 10 has a plasma processing space. The plasma processing chamber 10 further has at least one gas inlet for supplying at least one process gas into the plasma processing space and at least one gas outlet for exhausting gases from the plasma processing space. The gas inlet is connected to a gas supply 20 described below and the gas outlet is connected to a gas exhaust system 40 described below. The substrate support 11 is disposed in a plasma processing space and has a substrate supporting surface for supporting a substrate.

The plasma generator 12 is configured to generate a plasma from the at least one process gas supplied into the plasma processing space. The plasma formed in the plasma processing space may be, for example, a capacitively coupled plasma (CCP), an inductively coupled plasma (ICP), an electron-cyclotron-resonance (ECR) plasma, a helicon wave plasma (HWP), or a surface wave plasma (SWP). Various types of plasma generators may also be used, such as an alternating current (AC) plasma generator and a direct current (DC) plasma generator. In an embodiment, AC signal (AC power) used in the AC plasma generator has a frequency in a range of 100 kHz to 10 GHz. Hence, examples of the AC signal include a radio frequency (RF) signal and a microwave signal. In an embodiment, the RF signal has a frequency in a range of 100 kHz to 150 MHz.

The controller 2 processes computer executable instructions causing the plasma processing apparatus 1 to perform various steps described in this disclosure. The controller 2 may be configured to control individual components of the plasma processing apparatus 1 such that these components execute the various steps. In an embodiment, the functions of the controller 2 may be partially or entirely incorporated into the plasma processing apparatus 1. The controller 2 may include a processor 2a1, a storage 2a2, and a communication interface 2a3. The controller 2 is implemented in, for example, a computer 2a. The processor 2a1 may be configured to read a program from the storage 2a2, and then perform various controlling operations by executing the program. This program may be preliminarily stored in the storage 2a2 or retrieved from any medium, as appropriate. The resulting program is stored in the storage 2a2, and then the processor 2a1 reads to execute the program from the storage 2a2. The medium may be of any type which can be accessed by the computer 2a or may be a communication line connected to the communication interface 2a3. The processor 2a1 may be a central processing unit (CPU). The storage 2a2 may include a random access memory (RAM), a read only memory (ROM), a hard disk drive (HDD), a solid state drive (SSD), or any combination thereof. The communication interface 2a3 can communicate with the plasma processing apparatus 1 via a communication line, such as a local area network (LAN).

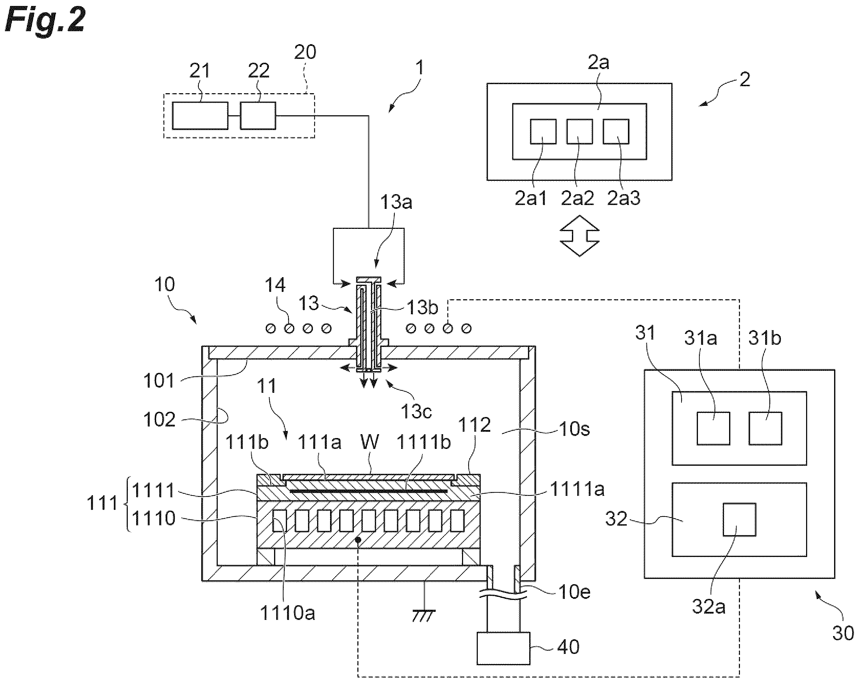

An example configuration of an inductively coupled plasma processing apparatus, which is an example of the plasma processing apparatus 1, will now be described. Fig. 2 illustrates the example configuration of the inductively coupled plasma processing apparatus.

The inductively coupled plasma processing apparatus 1 includes a plasma processing chamber 10, a gas supply 20, an electric power source 30, and a gas exhaust system 40. The plasma processing chamber 10 includes a dielectric window 101. The plasma processing apparatus 1 includes a substrate support 11, a gas introduction unit, and an antenna 14. The substrate support 11 is disposed in the plasma processing chamber 10. The antenna 14 is disposed on or above the plasma processing chamber 10 (i.e., on or above the dielectric window 101). The plasma processing chamber 10 has a plasma processing space 10s that is defined by the dielectric window 101, the sidewall 102 of the plasma processing chamber 10, and the substrate support 11. The plasma processing chamber 10 is grounded.

The substrate support 11 includes a body 111 and a ring assembly 112. The body 111 has a central region 111a for supporting a substrate W and an annular region 111b for supporting the ring assembly 112. An example of the substrate W is a wafer. The annular region 111b of the body 111 surrounds the central region 111a of the body 111 in plan view. The substrate W is disposed on the central region 111a of the body 111, and the ring assembly 112 is disposed on the annular region 111b of the body 111 so as to surround the substrate W on the central region 111a of the body 111. Thus, the central region 111a is also called a substrate supporting surface for supporting the substrate W, while the annular region 111b is also called a ring supporting surface for supporting the ring assembly 112.

In an embodiment, the body 111 includes a base 1110 and an electrostatic chuck 1111. The base 1110 includes a conductive member. The conductive member of the base 1110 can function as a bias electrode. The electrostatic chuck 1111 is disposed on the base 1110. The electrostatic chuck 1111 includes a ceramic member 1111a and an electrostatic electrode 1111b disposed in the ceramic member 1111a. The ceramic member 1111a has the central region 111a. In an embodiment, the ceramic member 1111a also has the annular region 111b. Any other member, such as an annular electrostatic chuck or an annular insulting member, surrounding the electrostatic chuck 1111 may have the annular region 111b. In this case, the ring assembly 112 may be disposed on either the annular electrostatic chuck or the annular insulating member, or both the annular electrostatic chuck 1111 and the annular insulating member. At least one RF/DC electrode coupled to a radio frequency (RF) source 31 and/or a direct current (DC) source 32 described below may be disposed in the ceramic member 1111a. In this case, the at least one RF/DC electrode functions as the bias electrode. It is noted that the conductive member of the base 1110 and the at least one RF/DC electrode may each function as a bias electrode. The electrostatic electrode 1111b may also be function as a bias electrode. The substrate support 11 accordingly includes at least one bias electrode.

The ring assembly 112 includes one or more annular members. In an embodiment, the annular members include one or more edge rings and at least one cover ring. The edge ring is composed of a conductive or insulating material, whereas the cover ring is composed of an insulating material.

The substrate support 11 may also include a temperature adjusting module that is configured to adjust at least one of the electrostatic chuck 1111, the ring assembly 112, and the substrate to a target temperature. The temperature adjusting module may be a heater, a heat transfer medium, a flow passage 1110a, or any combination thereof. A heat transfer fluid, such as brine or gas, flows into the flow passage 1110a. In an embodiment, the flow passage 1110a is formed in the base 1110, one or more heaters are disposed in the ceramic member 1111a of the electrostatic chuck 1111. The substrate support 11 may further include a heat transfer gas supply configured to supply a heat transfer gas to a gap between the rear surface of the substrate W and the central region 111a.

The gas introduction unit is configured to introduce the at least one process gas from the gas supply 20 into the plasma processing space 10s. In an embodiment, the gas introduction unit includes a center gas injector (CGI) 13. The CGI 13 is disposed above the substrate support 11 and attached to a central opening formed in the dielectric window 101. The CGI 13 has at least one gas inlet 13a, at least one gas flow passage 13b, and at least one gas introduction port 13c. The process gas supplied to the gas inlet 13a flows through the gas flow passage 13b and is then introduced into the plasma processing space 10s from the gas introduction port 13c. The gas introduction unit may include one or more side gas injectors (SGIs) attached to one or more openings formed in the sidewall 102, in addition to or in place of the CGI 13.

The gas supply 20 may include at least one gas source 21 and at least one flow controller 22. In an embodiment, the gas supply 20 is configured to supply at least one process gas from the corresponding gas source 21 through the corresponding flow controller 22, into the gas introduction unit. Each flow controller 22 may be, for example, a mass flow controller or pressure-controlled flow controller. The gas supply 20 may include one or more flow modulation devices that can modulate or pulse the flow of the at least one process gas.

The electric power source 30 include an RF source 31 coupled to the plasma processing chamber 10 through at least one impedance matching circuit. The RF source 31 is configured to supply at least one RF signal (RF power) to at least one bias electrode and/or the antenna 14. A plasma is thereby formed from at least one process gas supplied into the plasma processing space 10s. Thus, the RF source 31 can function as at least part of the plasma generator 12. The bias RF signal supplied to the at least one bias electrode causes a bias potential to occur in the substrate W, which potential then attracts ionic components in the plasma to the substrate W.

In an embodiment, the RF source 31 includes a first RF generator 31a and a second RF generator 31b. The first RF generator 31a is coupled to the antenna 14 through the at least one impedance matching circuit and is configured to generate a source RF signal (source RF power) for generating a plasma. In an embodiment, the source RF signal has a frequency in a range of 10 MHz to 150 MHz. In an embodiment, the first RF generator 31a may be configured to generate two or more source RF signals having different frequencies. The resulting source RF signal(s) is supplied to the antenna 14.

The second RF generator 31b is coupled to the at least one lower electrode through the at least one impedance matching circuit and is configured to generate a bias RF signal (bias RF power). The bias RF signal and the source RF signal may have the same frequency or different frequencies. In an embodiment, the bias RF signal has a frequency which is less than that of the source RF signal. In an embodiment, the bias RF signal has a frequency in a range of 100 kHz to 60 MHz. In an embodiment, the second RF generator 31b may be configured to generate two or more bias RF signals having different frequencies. The resulting bias RF signal(s) is supplied to the at least one lower electrode. In various embodiments, at least one of the source RF signal and the bias RF signal may be pulsated.

The electric power source 30 may also include a DC source 32 coupled to the plasma processing chamber 10. The DC source 32 includes a bias DC generator 32a. In an embodiment, the bias DC generator 32a is connected to at least one bias electrode and is configured to generate a bias DC signal. The resulting bias DC signal is applied to the at least one bias electrode.

In various embodiments, the bias DC signal may be a pulsed. In this case, a sequence of voltage pulses is applied to the at least one bias electrode. The voltage pulses have rectangular, trapezoidal, or triangular waveform, or a combined waveform thereof. In an embodiment, a waveform generator for generating a sequence of voltage pulses from the DC signal is disposed between the bias DC generator 32a and the at least one bias electrode. The bias DC generator 32a and the waveform generator thereby functions as a voltage pulse generator. The voltage pulse may have positive polarity or negative polarity. A sequence of voltage pulses may also include one or more positive voltage pulses and one or more negative voltage pulses in a cycle. The bias DC generator 32a may be disposed in addition to the RF power source 31, or the bias DC generator 32a may be disposed in place of the second RF generator 31b.

The antenna 14 includes one or more coils. In an embodiment, the antenna 14 may include an outer coil and an inner coil that are coaxially disposed. In this case, the RF source 31 may be connected to both the outer coil and the inner coil, or either the outer coil or the inner coil. In the former case, a single RF generator may be connected to the outer and inner coils, or different RF generators may be connected to the outer and inner coils, respectively.

The gas exhaust system 40 may be connected to, for example, the gas outlet 10e provided in the bottom wall of the plasma processing chamber 10. The gas exhaust system 40 may include a pressure regulation valve and a vacuum pump. The pressure regulation valve enables the pressure in the plasma processing space 10s to be adjusted. The vacuum pump may be a turbo-molecular pump, a dry pump, or a combination thereof.

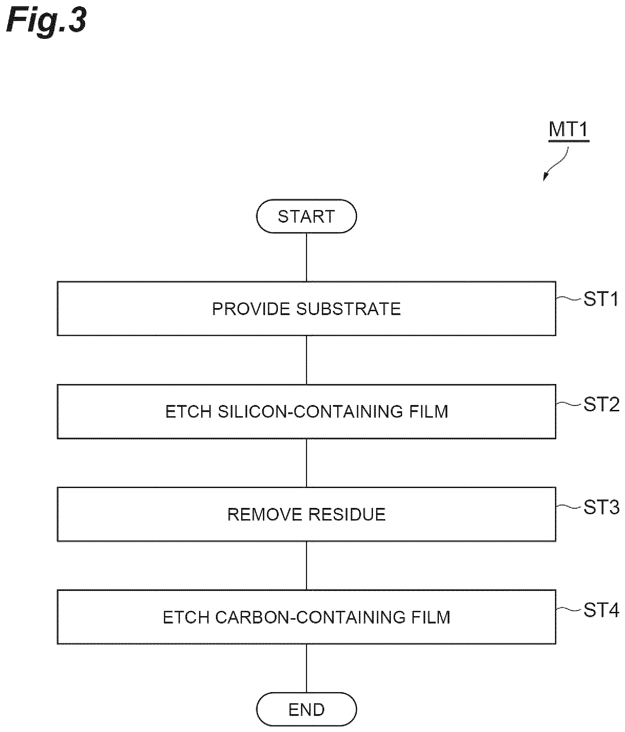

FIG. 3 is a flowchart illustrating a substrate processing method according to an example embodiment. The substrate processing method MT1 illustrated in FIG. 3 (hereinafter, referred to as "method MT1") may be performed by a plasma processing apparatus 1 of the above-described embodiment. The method MT1 may be applied to a substrate W.

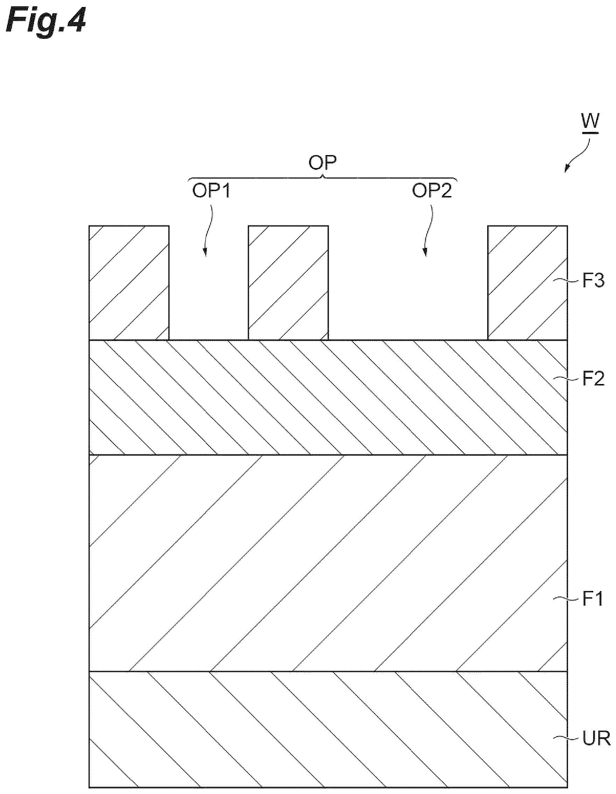

FIG. 4 is a cross-sectional view of an example of a substrate to which the method in FIG. 3 may be applied. As illustrated in FIG. 4, in one embodiment, the substrate W includes a silicon-containing film F2 and a metal-containing film F3 on the silicon-containing film F2. The substrate W may include a film different from the silicon-containing film F2, such as a carbon-containing film F1, under the silicon-containing film F2. The metal-containing film F3 has at least one opening OP. The at least one opening OP may have a hole pattern or may have a line pattern. The at least one opening OP may include a first opening OP1 and a second opening OP2. The second opening OP2 may have a width larger than a width of the first opening OP1. The substrate W may further include an underlying region UR. The carbon-containing film F1 may be provided on the underlying region UR.

The carbon-containing film F1 may include a spin-on carbon (SOC) film or may include an amorphous carbon film.

The silicon-containing film F2 may include a silicon oxide film, may include a silicon nitride film, or may include a silicon oxynitride film. The silicon-containing film F2 may include a spin-on-glass (SOG) film.

The metal-containing film F3 may include an EUV resist film. The metal-containing film F3 may include at least one selected from the group consisting of tin (Sn), hafnium (Hf), and titanium (Ti). The metal-containing film F3 may include at least one selected from the group consisting of tin oxide, hafnium oxide, and titanium oxide.

The underlying region UR may include a silicon-containing film. The silicon-containing film may include a silicon oxide film, may include a silicon nitride film, or may include a silicon oxynitride film.

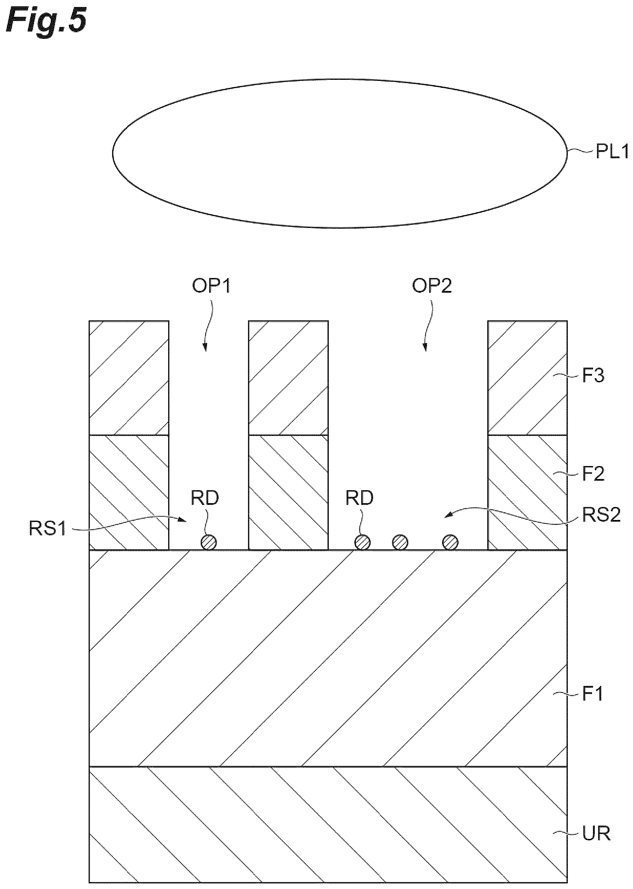

In the following, the method MT1 will be described with reference to FIGS. 3 to 7 by using, as an example, the case where the method MT1 is applied to the substrate W by using the plasma processing apparatus 1 in the above-described embodiment. Each of FIGS. 5 to 7 is a cross-sectional view illustrating a step of the substrate processing method according to the example embodiment. In a case where a plasma processing apparatus 1 is used, the method MT1 may be performed in the plasma processing apparatus 1 in a manner that a controller 2 controls each unit of the plasma processing apparatus 1. In the method MT1, as illustrated in FIG. 2, the substrate W on a substrate support 11 disposed in a plasma processing chamber 10 is processed.

As illustrated in FIG. 3, the method MT1 may include Step ST1 to Step ST4. Step ST1 to Step ST4 may be executed in order. The method MT1 may not include Step ST4.

### (Step ST1)

In Step ST1, the substrate W illustrated in FIG. 4 is provided. The substrate W may be supported by the substrate support 11 in the plasma processing chamber 10. At least one opening OP may be formed by development. The development may be performed by the plasma processing apparatus 1 or may be performed by a developing apparatus different from the plasma processing apparatus 1.

### (Step ST2)

In Step ST2, as illustrated in FIG. 5, the silicon-containing film F2 is etched using plasma PL1 generated from a first process gas. At least one recess corresponding to at least one opening OP may be formed in the silicon-containing film F2. A bottom of at least one recess may reach the carbon-containing film F1. The at least one recess may be at least one opening. A first recess RS1 and a second recess RS2 corresponding to the first opening OP1 and the second opening OP2, respectively, may be formed in the silicon-containing film F2.

The first process gas includes a fluorine-containing gas. The fluorine-containing gas may include at least one selected from the group consisting of a hydrogen fluoride gas (HF gas), a fluorocarbon gas, a hydrofluorocarbon gas, a nitrogen fluoride gas, and a sulfur fluoride gas. The fluorocarbon gas may include at least one selected from the group consisting of a C₄F₆ gas, a C₄F₈ gas, a C₃F₈ gas, and a CF₄ gas. The hydrofluorocarbon gas may include at least one selected from the group consisting of a CHF₃ gas and a CH₂F₂ gas. The nitrogen fluoride gas may include an NF₃ gas. The sulfur fluoride gas may include an SF₆ gas. The supply of the first process gas may be stopped at the end of Step ST2.

In Step ST2, a residue RD is generated. The residue RD may be disposed in the first recess RS1 and the second recess RS2. The residue RD may adhere to a surface of the carbon-containing film F1. The residue RD may adhere to a surface of the metal-containing film F3. The residue RD may include a metal fluoride. The metal fluoride may include a metal included in the metal-containing film F3. The residue RD may include at least one selected from the group consisting of tin fluoride, hafnium fluoride, and titanium fluoride.

### (Step ST3)

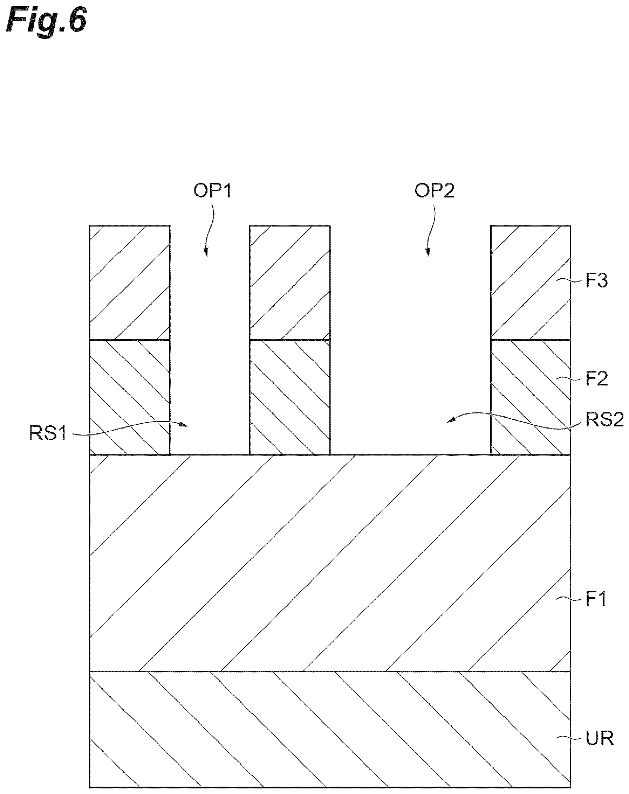

In Step ST3, the residue RD is removed by supplying a second process gas as illustrated in FIG. 6.

The second process gas is different from the first process gas. The second process gas may include a chlorine-containing gas. The second process gas may further contain an inert gas such as argon gas or nitrogen gas. In this case, the partial pressure of the chlorine-containing gas in the second process gas may be the highest among all the partial pressures of the gases in the second process gas. The chlorine-containing gas may include at least one selected from the group consisting of a silicon tetrachloride (SiCl₄) gas, a titanium tetrachloride (TiCl₄) gas, a dimethylaluminum chloride gas, a thionyl chloride (SOCl₂) gas, and an acetyl chloride (CH₃COCl) gas. The supply of the second process gas may be stopped at the end of Step ST3.

In Step ST3, the residue RD may be removed without generating plasma. In Step ST3, the residue RD may be removed by the plasma generated from the second process gas.

In Step ST3, the substrate W may be heated. The substrate W may be heated to 30°C or higher, 90°C or higher, or 120°C or higher, or may be heated to 300°C or lower.

### (Step ST4)

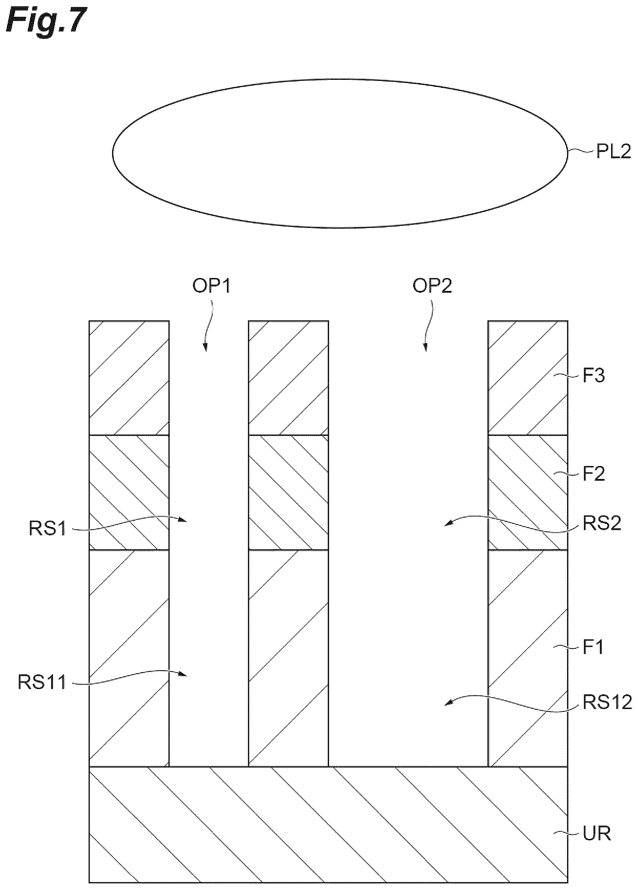

In Step ST4, the carbon-containing film F1 may be etched as illustrated in FIG. 7. The carbon-containing film F1 may be etched using plasma PL2 generated from the process gas. At least one recess corresponding to at least one opening OP may be formed in the carbon-containing film F1. The bottom of at least one recess may reach the underlying region UR. The at least one recess may be at least one opening. A third recess RS11 and a fourth recess RS12 corresponding to the first opening OP1 and the second opening OP2, respectively, may be formed in the carbon-containing film F1. The third recess RS11 and the fourth recess RS12 may correspond to the first recess RS1 and the second recess RS2, respectively.

The process gas in Step ST4 may include an oxygen-containing gas. Examples of the oxygen-containing gas include oxygen gas. The supply of the process gas may be stopped at the end of Step ST4.

According to the method MT1, in Step ST3, the residue RD can be removed by the reaction between the second process gas and the residue RD. For example, in Step ST3, volatile tin chloride is generated due to a ligand exchange reaction between the chlorine-containing gas and the tin fluoride. In a case where plasma is not generated in Step ST3, etching or damage to the substrate W caused by plasma can be suppressed. Accordingly, the residue RD can be selectively removed. In a case where the substrate W is heated in Step ST3, the reaction between the second process gas and the residue RD can be promoted.

Step ST2 and Step ST3 may be performed in the same plasma processing chamber 10. Step ST2 and Step ST3 may be performed in-situ. Step ST2 to Step ST4 may be performed in the same plasma processing chamber 10. Step ST2 to Step ST4 may be performed in-situ.

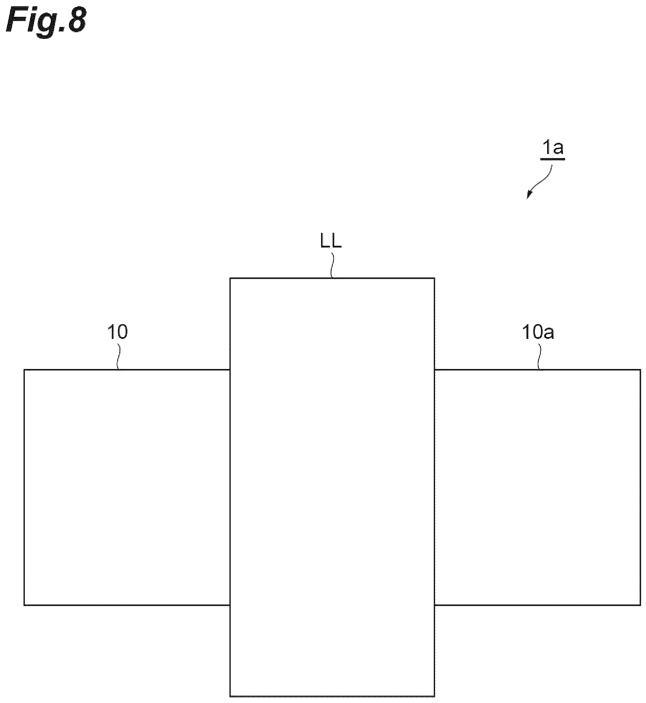

FIG. 8 is a schematic diagram illustrating a part of the substrate processing apparatus according to an example embodiment. A plasma processing apparatus 1a illustrated in FIG. 8 has the same configuration as the plasma processing chamber 10 of the plasma processing apparatus 1 of FIG. 2, except that the plasma processing apparatus 1a further includes a load lock chamber LL and a plasma processing chamber 10a. The plasma processing chamber 10a may have the same configuration as the plasma processing chamber 10. The substrate W may be tranfered between the plasma processing chamber 10 and the plasma processing chamber 10a through the load lock chamber LL.

The method MT1 of FIG. 3 may be performed by the plasma processing apparatus 1a of FIG. 8. The method MT1 may be applied to a substrate W. In a case where the plasma processing apparatus 1a is used, the method MT1 can be performed in the plasma processing apparatus 1a in a manner that the controller 2 controls each unit of the plasma processing apparatus 1a. In this case, Step ST2 and Step ST3 may be performed in different chambers. Step ST2 of the method MT1 may be performed in the plasma processing chamber 10, and Step ST3 of the method MT1 may be performed in the plasma processing chamber 10a.

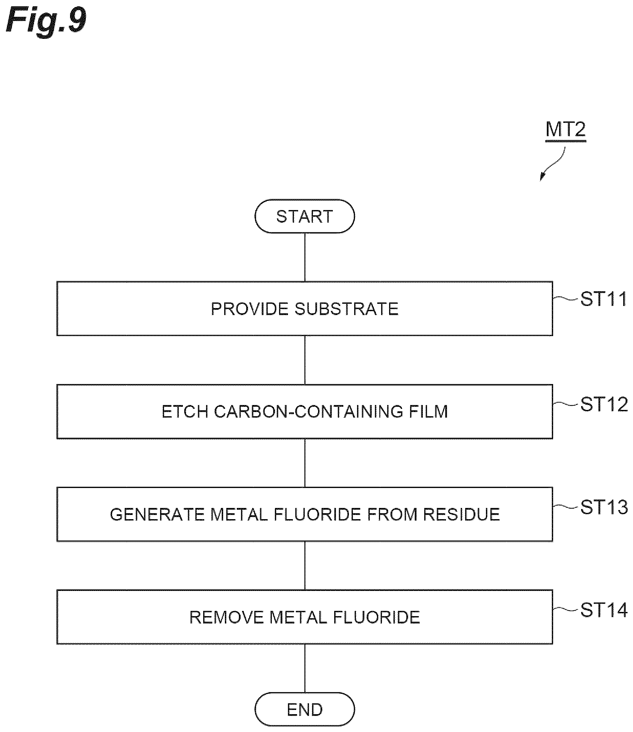

FIG. 9 is a flowchart illustrating a substrate processing method according to an example embodiment. A substrate processing method MT2 illustrated in FIG. 9 (hereinafter, referred to as a "method MT2") may be performed by the plasma processing apparatus 1 or the plasma processing apparatus 1a of the above-described embodiment.

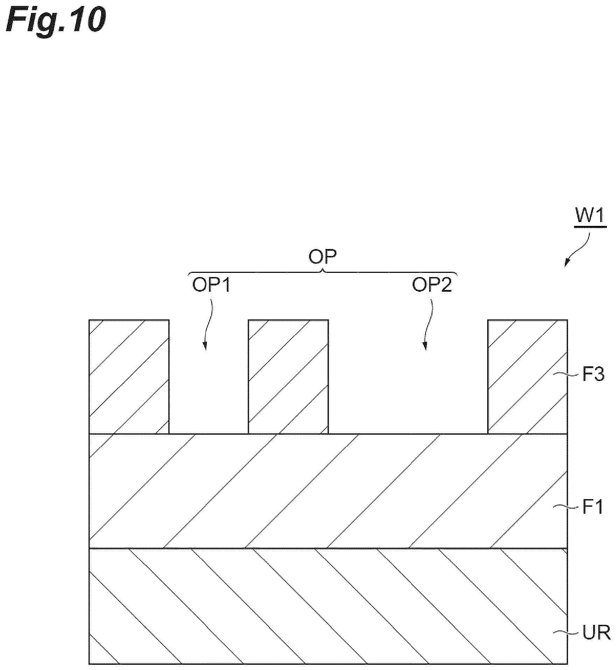

FIG. 10 is a cross-sectional view of an example of a substrate to which the method in FIG. 9 may be applied. As illustrated in FIG. 10, in one embodiment, a substrate W1 includes the carbon-containing film F1 and the metal-containing film F3 on the carbon-containing film F1. The substrate W1 may further include the underlying region UR. The substrate W1 may have the same configuration as the substrate W of FIG. 4 except that the silicon-containing film F2 is not provided. The method MT2 may be applied to a substrate W1.

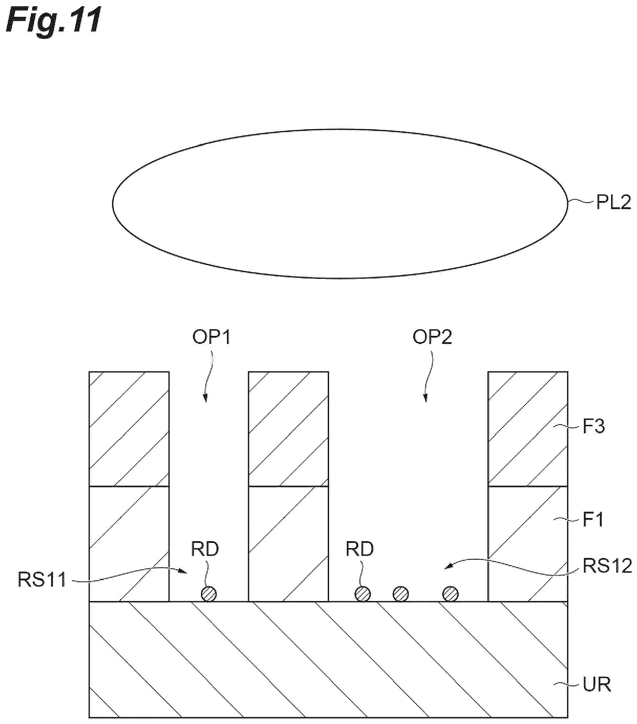

In the following, the method MT2 will be described with reference to FIGS. 9 to 13 by using, as an example, the case where the method MT2 is applied to the substrate W1 by using the plasma processing apparatus 1 in the above-described embodiment. Each of FIGS. 11 to 13 is a cross-sectional view illustrating a step of the substrate processing method according to the example embodiment. In a case where the plasma processing apparatus 1 is used, the method MT2 can be performed in the plasma processing apparatus 1 in a manner that the controller 2 controls each unit of the plasma processing apparatus 1. In the method MT2, as illustrated in FIG. 2, the substrate W1 on a substrate support 11 disposed in a plasma processing chamber 10 is processed.

As illustrated in FIG. 9, the method MT2 can include Step ST11 to Step ST14. Step ST11 to Step ST14 may be executed in order.

### (Step ST11)

In Step ST11, the substrate W1 illustrated in FIG. 10 is provided. The substrate W1 may be supported by the substrate support 11 in the plasma processing chamber 10.

### (Step ST12)

In Step ST12, as illustrated in FIG. 11, the carbon-containing film F1 is etched using the plasma PL2 generated from the first process gas including an oxygen-containing gas. At least one recess corresponding to at least one opening OP may be formed in the carbon-containing film F1. The bottom of at least one recess may reach the underlying region UR. The at least one recess may be at least one opening. A third recess RS11 and a fourth recess RS12 corresponding to the first opening OP1 and the second opening OP2, respectively, may be formed in the carbon-containing film F1.

The first process gas in Step ST12 may be the same as the process gas in Step ST4. The supply of the first process gas may be stopped at the end of Step ST12.

In Step ST12, the residue RD is generated. The residue RD may be disposed in the third recess RS11 and the fourth recess RS12. The residue RD may adhere to the surface of the underlying region UR. The residue RD may adhere to side walls of the third recess RS11 and the fourth recess RS12. The residue RD may adhere to a surface of the metal-containing film F3. The residue RD may include a metal oxide. The metal oxide includes the metal included in the metal-containing film F3. The residue RD may include at least one selected from the group consisting of tin oxide, hafnium oxide, and titanium oxide.

### (Step ST13)

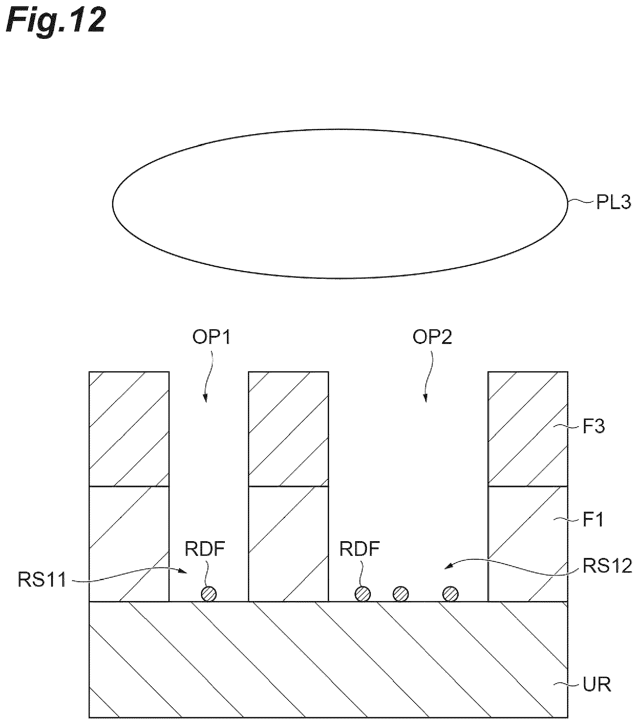

In Step ST13, as illustrated in FIG. 12, a metal fluoride RDF is generated from the residue RD by the second process gas containing a fluorine-containing gas. The metal fluoride RDF may be generated by plasma PL3 generated from the second process gas. The metal fluoride RDF may include at least one selected from the group consisting of tin fluoride, hafnium fluoride, and titanium fluoride.

The second process gas in Step ST13 may be the same as the first process gas in Step ST2. The supply of the second process gas may be stopped at the end of Step ST13.

### (Step ST14)

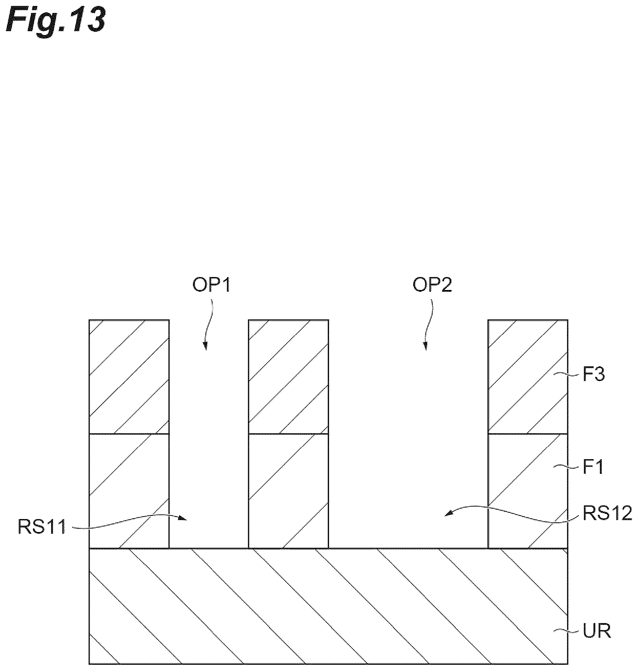

In Step ST14, as illustrated in FIG. 13, the metal fluoride RDF is removed by supplying a third process gas different from the second process gas in Step ST13.

The third process gas in Step ST14 may be the same as the second process gas in Step ST3. The supply of the third process gas may be stopped at the end of Step ST14.

Step ST14 may be performed in the same manner as Step ST3. In Step ST14, the metal fluoride RDF may be removed without generating plasma. In Step ST14, the metal fluoride RDF may be removed by the plasma generated from the third process gas. In Step ST14, the substrate W1 may be heated. The substrate W1 may be heated to 30°C or higher, may be heated to 90°C or higher, or may be heated to 120°C or higher, or may be heated to 300°C or lower.

According to the method MT2, in Step ST14, the metal fluoride RDF can be removed by the reaction between the third process gas and the metal fluoride RDF. Therefore, the residue RD generated in Step ST12 can be removed. For example, in Step ST14, volatile tin chloride is generated due to a ligand exchange reaction between the chlorine-containing gas and the tin fluoride. In a case where plasma is not generated in Step ST14, etching or damage to the substrate W1 caused by plasma can be suppressed. Accordingly, the metal fluoride RDF can be selectively removed. In a case where the substrate W1 is heated in Step ST14, the reaction between the third process gas and the metal fluoride RDF can be promoted.

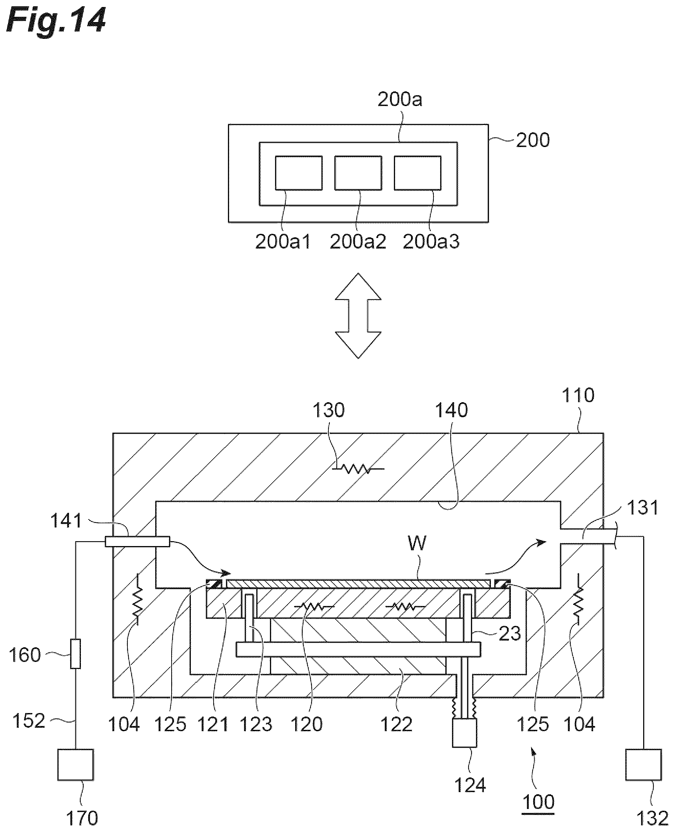

FIG. 14 is a diagram for describing a configuration example of the heat treatment system. In one example embodiment, the heat treatment system includes a heat treatment apparatus 100 and a controller 200. The heat treatment system is an example of a substrate processing system. The heat treatment apparatus 100 is an example of a substrate processing apparatus. In the method MT1 or the method MT2, the heating may be performed by the heat treatment system of FIG. 14.

The heat treatment apparatus 100 has a processing chamber 110 (chamber) that is configured to be sealable. The processing chamber 110 is, for example, an airtight cylindrical container, and is configured to control the atmosphere inside. A side wall heater 104 is provided on a side wall of the processing chamber 110. A ceiling heater 130 is provided on a ceiling wall (top plate) of the processing chamber 110. A ceiling surface 140 of a ceiling wall (top plate) of the processing chamber 110 is formed as a horizontal flat surface, for example. A temperature of the ceiling surface 140 is controlled by the ceiling heater 130.

A substrate support 121 is provided on a lower side in the processing chamber 110. The substrate support 121 constitutes a placing portion on which the substrate W is placed. The substrate support 121 may have, for example, a circular surface (upper surface) or may have a surface (upper surface) formed horizontally. The substrate W is placed on a surface of the substrate support 121. A stage heater 120 is embedded in the substrate support 121. The stage heater 120 is capable of heating the substrate W placed on the substrate support 121. A ring assembly 125 may be disposed on the substrate support 121 to surround the substrate W. The ring assembly 125 may include one or a plurality of annular members. By disposing the ring assembly 125, it is possible to improve the temperature controllability of an outer peripheral region of the substrate W. The ring assembly 125 may be made of inorganic materials or organic materials depending on the desired heat treatment.

The substrate support 121 is supported in the processing chamber 110 by a column 122 provided on a bottom surface of the processing chamber 110. A plurality of lift pins 123 that, for example, vertically move are provided on an outer side of the column 122 in a circumferential direction. The plurality of lift pins 123 are each inserted into a plurality of through-holes provided at intervals in the circumferential direction of the substrate support 121. The lifting operation of the lift pin 123 is controlled by a lift mechanism 124. In a case where the lift pin 123 protrudes from the surface of the substrate support 121, the substrate W is delivered between a transfer mechanism (not illustrated) and the substrate support 121.

An exhaust port 131 having an opening is provided on a side wall of the processing chamber 110. The exhaust port 131 is connected to an exhaust mechanism 132 via an exhaust pipe. The exhaust mechanism 132 is made of a vacuum pump, a valve, and the like, and adjusts an exhaust flow rate from the exhaust port 131. The pressure in the processing chamber 110 is adjusted by adjusting the exhaust flow rate and the like by means of the exhaust mechanism 132. A transfer port (not illustrated) of the substrate W is formed to be openable and closable, on a side wall of the processing chamber 110 at a position different from a position of the exhaust port 131.

In addition, a gas nozzle 141 is provided at a position different from the positions of the exhaust port 131 and the transfer port of the substrate W on the side wall of the processing chamber 110. The gas nozzle 141 supplies the process gas into the processing chamber 110. The gas nozzle 141 is provided on a side opposite to the exhaust port 131 as viewed from a central portion of the substrate support 121, on the side wall of the processing chamber 110.

The gas nozzle 141 is formed in a rod shape that protrudes from the side wall of the processing chamber 110 toward the center side of the processing chamber 110. A distal end of the gas nozzle 141 extends, for example, horizontally from the side wall of the processing chamber 110. The process gas is discharged into the processing chamber 110 from a discharge port provided at the distal end of the gas nozzle 141. The discharged process gas flows in a direction of an arrow illustrated in FIG. 1 and is exhausted from the exhaust port 131. The distal end of the gas nozzle 141 may extend obliquely downward toward the substrate W, or may extend obliquely upward toward the ceiling surface 140 of the processing chamber 110.

The gas nozzle 141 may be provided, for example, on the ceiling wall of the processing chamber 110. The exhaust port 131 may be provided on the bottom surface of the processing chamber 110.

The heat treatment apparatus 100 has a gas supply pipe 152 connected to the gas nozzle 141 from the outer side of the processing chamber 110. A pipe heater 160 for heating an inside of the gas supply pipe 152 is provided around the gas supply pipe 152. The gas supply pipe 152 is connected to a gas supply 170. The gas supply 170 includes at least one gas source and at least one flow rate control device. The gas supply may include a vaporizer that vaporizes a gas source in a liquid state.

The controller 200 processes computer-executable instructions for causing the heat treatment apparatus 100 to execute various steps described in the present disclosure. The controller 200 may be configured to control each element of the heat treatment apparatus 100 to execute various steps described herein. In one embodiment, a part or all of the controller 200 may be included in the heat treatment apparatus 100. The controller 200 may include a processor 200a1, a storage 200a2, and a communication interface 200a3. The controller 200 is realized by, for example, a computer 200a. The processor 200a1 can be configured to read out a program from the storage 200a2 and execute the read out program to perform various control operations. This program may be stored in the storage 200a2 in advance, or may be acquired via the medium when necessary. The acquired program is stored in the storage 200a2, and is read out from the storage 200a2 and executed by the processor 200a1. The medium may be various storage media readable by the computer 200a, or may be a communication line connected to the communication interface 200a3. The processor 200a1 may be a central processing unit (CPU). The storage 200a2 may include a random access memory (RAM), a read only memory (ROM), a hard disk drive (HDD), a solid state drive (SSD), or combinations thereof. The communication interface 200a3 may communicate with the heat treatment apparatus 100 via a communication line such as a local area network (LAN).

Although the various example embodiments have been described above, various additions, omissions, substitutions, and changes may be made without being limited to the example embodiments described above. Other embodiments can be formed by combining elements in different embodiments.

Here, the various example embodiments included in the present disclosure are described in [E1] to [E17] below.

### [E1]

A substrate processing method comprising:
(a) providing a substrate including a silicon-containing film and a metal-containing film on the silicon-containing film, the metal-containing film comprising at least one opening;
(b) etching the silicon-containing film with plasma generated from a first process gas including a fluorine-containing gas; and
(c) removing a residue generated in the (b) by supplying a second process gas different from the first process gas, the residue including a metal and fluorine included in the metal-containing film.

According to the method [E1], the residue can be removed by a reaction between the second process gas and the residue.

### [E2]

The substrate processing method according to [E1],
wherein the metal-containing film includes tin,
the residue includes tin fluoride, and
the second process gas includes a chlorine-containing gas.

In this case, volatile tin chloride is generated by a reaction between the chlorine-containing gas and the tin fluoride.

### [E3]

The substrate processing method according to [E2],
wherein the chlorine-containing gas includes at least one selected from the group consisting of a silicon tetrachloride gas, a titanium tetrachloride gas, a dimethylaluminum chloride gas, a thionyl chloride gas, and an acetyl chloride gas.

### [E4]

The substrate processing method according to any one of [E1]to [E3],
wherein in the (c), the residue is removed without generating the plasma.

In this case, the residue can be selectively removed as compared with a case where plasma is generated.

### [E5]

The substrate processing method according to any one of [E1] to [E4],
wherein in the (c), the substrate is heated.

In this case, a reaction between the second process gas and the residue can be promoted.

### [E6]

The substrate processing method according to [E5],
wherein, in the (c), the substrate is heated to 30°C or higher.

### [E7]

The substrate processing method according to any one of [E1] to [E6],
wherein the silicon-containing film includes a silicon oxide film.

### [E8]

The substrate processing method according to any one of [E1] to [E7],
wherein the metal-containing film includes an EUV resist film.

### [E9]

The substrate processing method according to any one of [E1] to [E8],
wherein the fluorine-containing gas includes at least one selected from the group consisting of a hydrogen fluoride gas, a fluorocarbon gas, a hydrofluorocarbon gas, a nitrogen fluoride gas, and a sulfur fluoride gas.

### [E10]

The substrate processing method according to any one of [E1] to [E9],
wherein the substrate includes another film different from the silicon-containing film under the silicon-containing film, and
the substrate processing method further comprises (d) etching the another film after the (c).

### [E11]

The substrate processing method according to [E10],
wherein the another film includes a carbon-containing film.

### [E12]

The substrate processing method according to [E10],
wherein the another film includes a spin-on-carbon film.

### [E13]

The substrate processing method according to any one of [E1] to [E12],
wherein the (b) and the (c) are performed in a same chamber.

### [E14]

The substrate processing method according to any one of [E1] to [E13],
wherein the (b) and the (c) are performed in different chambers.

### [E15]

The substrate processing method according to any one of [E1] to [E14],
wherein the at least one opening includes a first opening and a second opening, and the second opening has a width larger than a width of the first opening.

### [E16]

A substrate processing method comprising:
(a) providing a substrate including a carbon-containing film and a metal-containing film on the carbon-containing film, the metal-containing film including at least one opening;
(b) etching the carbon-containing film with plasma generated from a first process gas including an oxygen-containing gas;
(c) generating a metal fluoride from a residue generated in the (b) with a second process gas including a fluorine-containing gas, the residue including a metal included in the metal-containing film; and
(d) removing the metal fluoride by supplying a third process gas different from the second process gas.

According to the method [E16], the metal fluoride can be removed by a reaction between the third process gas and the metal fluoride in the (d). Accordingly, the residue generated in the (b) can be removed.

### [E17]

A substrate processing apparatus comprising:
a chamber;
a substrate support for supporting a substrate in the chamber, the substrate including a silicon-containing film and a metal-containing film on the silicon-containing film, and the metal-containing film including at least one opening;
a gas supply configured to supply a first process gas and a second process gas into the chamber, the first process gas including a fluorine-containing gas and the second process gas being different from the first process gas;
a plasma generator configured to generate plasma from the first process gas in the chamber; and
a controller configured to control the gas supply and the plasma generator to
   etch the silicon-containing film with the plasma, and
   remove a residue generated in the etching of the silicon-containing film by supplying the second process gas, the residue including a metal and fluorine included in the metal-containing film.

From the foregoing description, it will be appreciated that various embodiments of the present disclosure have been described herein for purposes of illustration, and that various modifications may be made without departing from the scope and spirit of the present disclosure. Accordingly, the various embodiments disclosed herein are not intended to be limiting, with the true scope and spirit being indicated by the following claims.

### Reference Signs List

1: plasma processing apparatus
2: controller
10: plasma processing chamber
11: substrate support
12: plasma generator
20: gas supply
F1: carbon-containing film
F2: silicon-containing film
F3: metal-containing film
OP: opening
PL1: plasma
RD: residue
RDF: metal fluoride
W: substrate

## Claims

1. A substrate processing method comprising:
(a) providing a substrate including a silicon-containing film and a metal-containing film on the silicon-containing film, the metal-containing film including at least one opening;
(b) etching the silicon-containing film with plasma generated from a first process gas including a fluorine-containing gas; and
(c) removing a residue generated in the (b) by supplying a second process gas different from the first process gas, the residue including a metal and fluorine included in the metal-containing film.

2. The substrate processing method according to Claim 1,
wherein the metal-containing film includes tin,
the residue includes tin fluoride, and
the second process gas includes a chlorine-containing gas.

3. The substrate processing method according to Claim 2,
wherein the chlorine-containing gas includes at least one selected from the group consisting of a silicon tetrachloride gas, a titanium tetrachloride gas, a dimethylaluminum chloride gas, a thionyl chloride gas, and an acetyl chloride gas.

4. The substrate processing method according to any one of Claims 1 to 3,
wherein in the (c), the residue is removed without generating the plasma.

5. The substrate processing method according to any one of Claims 1 to 3,
wherein in the (c), the substrate is heated.

6. The substrate processing method according to Claim 5,
wherein, in the (c), the substrate is heated to 30°C or higher.

7. The substrate processing method according to any one of Claims 1 to 3,
wherein the silicon-containing film includes a silicon oxide film.

8. The substrate processing method according to any one of Claims 1 to 3,
wherein the metal-containing film includes an EUV resist film.

9. The substrate processing method according to any one of Claims 1 to 3,
wherein the fluorine-containing gas includes at least one selected from the group consisting of a hydrogen fluoride gas, a fluorocarbon gas, a hydrofluorocarbon gas, a nitrogen fluoride gas, and a sulfur fluoride gas.

10. The substrate processing method according to any one of Claims 1 to 3,
wherein the substrate includes another film different from the silicon-containing film under the silicon-containing film, and
the substrate processing method further comprises (d) etching the another film after the (c).

11. The substrate processing method according to Claim 10,
wherein the another film includes a carbon-containing film.

12. The substrate processing method according to Claim 10,
wherein the another film includes a spin-on-carbon film.

13. The substrate processing method according to any one of Claims 1 to 3,
wherein the (b) and the (c) are performed in a same chamber.

14. The substrate processing method according to any one of Claims 1 to 3,
wherein the (b) and the (c) are performed in different chambers.

15. The substrate processing method according to any one of Claims 1 to 3,
wherein the at least one opening includes a first opening and a second opening, and the second opening has a width larger than a width of the first opening.

16. A substrate processing method comprising:
(a) providing a substrate including a carbon-containing film and a metal-containing film on the carbon-containing film, the metal-containing film including at least one opening;
(b) etching the carbon-containing film with plasma generated from a first process gas including an oxygen-containing gas;
(c) generating a metal fluoride from a residue generated in the (b) with a second process gas including a fluorine-containing gas, the residue including a metal included in the metal-containing film; and
(d) removing the metal fluoride by supplying a third process gas different from the second process gas.

17. A substrate processing apparatus comprising:
a chamber;
a substrate support for supporting a substrate in the chamber, the substrate including a silicon-containing film and a metal-containing film on the silicon-containing film, and the metal-containing film including at least one opening;
a gas supply configured to supply a first process gas and a second process gas into the chamber, the first process gas including a fluorine-containing gas, the second process gas being different from the first process gas;
a plasma generator configured to generate plasma from the first process gas in the chamber; and
a controller configured to control the gas supply and the plasma generator to
etch the silicon-containing film with the plasma, and
remove a residue generated in the etching of the silicon-containing film by supplying the second process gas, the residue including a metal and fluorine included in the metal-containing film.
